# EUROPEAN PATENT APPLICATION

(11) **EP 4 727 327 A1**
(43) Date of publication of application: **15.04.2026**
(21) Application number: 25205501.7
(22) Date of filing: 30.09.2025
(51) Int. Cl.: H10W 70/40, H10W 72/60, H10W 72/00, H10W 70/04

(54) **A CLIP-BONDED SEMICONDUCTOR PACKAGE AND CORRESPONDING METHOD OF MANUFACTURING SUCH A SEMICONDUCTOR PACKAGE**

(30) Priority: 30.09.2024 NL 2038742
(71) Applicant: Nexperia B.V., 6534 AB Nijmegen (NL)
(72) Inventor: Böttcher, Tim, Hamburg (DE); Vu, Hoan, Hamburg (DE); Fan, Haibo, Hong Kong (HK); Yahaya, Khairul Ikhsan, Seremban (MY); Ho, Wai Keung, Hong Kong (HK); Ng, To Kam, Hong Kong (HK); Bernhardt, Dirk, Hamburg (DE)
(74) Representative: Pjanovic, Ilija

(57) **Abstract**

A clip-bonded semiconductor package comprising: a semiconductor die comprising a bond pad on a top side of the semiconductor die, wherein the bond pad is arranged to receive a bond clip, the bond clip arranged to provide electrical connection to the bond pad via a connection part of the bond clip, wherein the bond clip further comprises a buffer layer provided to at least the connection part, wherein a hardness of a material of the buffer layer is lower than a hardness of a material of the bond clip.

## Description

### Technical Field

The present disclosure is directed to an improved clip-bonded semiconductor package and, more specifically, to a clip-bonded semiconductor package arranged such that there is less mechanical stress between a corresponding bond clip and the semiconductor die.

### Background

In semiconductor packaging, the connection between a semiconductor die and a bond clip, which allows electrical connection to other parts of a semiconductor package is of importance to ensure reliable electrical and mechanical performance. Traditionally, solder has been used to provide a stress-buffering layer between the die and the bond clip, helping to accommodate differences in thermal expansion and to mitigate mechanical stresses. This solder typically acts as a compliant material that absorbs and dissipates stresses, reducing the risk of damage such as cratering or delamination.

In certain advanced packaging designs, clips are used to establish connections between the semiconductor die and the package. These clips often incorporate solder to facilitate electrical contact. However, the distribution of this solder may not be uniform. Instead, solder is typically concentrated near the edges of the clip contact area, with the center of the connection often lacking any soft solder but with hard intermetallic compound, IMC.

A problem arises because the central region of the clip connection, which is devoid of solder, may not benefit from the stress-buffering properties that solder provides. When thermal cycling occurs, the concentrated solder at the edges may not be sufficient to buffer the stress experienced at the center of the connection. This localized stress at the IMC regions can lead to point contact stresses, which are higher due to the lack of a uniform stress distribution. Such stresses can contribute to phenomena like cratering, where localized damage occurs on the die's surface.

Cratering is a form of damage that manifests as small, crater-like voids or depressions on the die's surface, usually at points where stress is most concentrated. The absence of stress buffering solder in the center means that this region bears a disproportionate amount of stress, making it vulnerable to mechanical failures and impacting the overall reliability of the semiconductor device.

### Summary

It would be advantageous to achieve a semiconductor package, comprising a bond clip and a semiconductor die, which is able to reduce the problem of cratering by introducing a connection which better handles stresses.

In the first aspect of the present disclosure, there is provided a clip-bonded semiconductor package comprising:
- a semiconductor die comprising a bond pad on a top side of the semiconductor die, wherein the bond pad is arranged to receive a bond clip;
- the bond clip arranged to provide electrical connection to the bond pad via a connection part of the bond clip, wherein the bond clip further comprises a buffer layer provided to at least the connection part, wherein a hardness of a material of the buffer layer is lower than a hardness of a material of the bond clip

The inventors have found that it may be beneficial to provide a clip bonded semiconductor package wherein at least the connection part of the bond clip is at least partly covered by a buffer layer.

This buffer layer comprises a material with a lower hardness than that of the further bond clip, and allows for an improved stress buffering, at least compared to the material of the bond clip, which is typically copper alloy or a similar material.

This results in a reduction in the stress, and therefore the likelihood of a cratering event, at the connection point of the bond clip and the semiconductor die. This then leads to an improvement of the reliability of the package.

Another advantage related to thermal capacity. The design of the package allows for sufficient thermal capacity to limit the temperature increase during forward surge current loads.

Typically, a forward surge current in semiconductor dies refers to the maximum peak current that a semiconductor device, like a diode or thyristor, can withstand for a short duration when forward biased. This is a transient current that exceeds the device's normal forward current rating, often occurring due to voltage spikes, switching surges, or inrush currents when powering on a circuit.

In an example of the disclosure, the bond clip is soldered to the bond pad.

In order to create a mechanical and electrical connection between the bond pad and the bond clip, the bond clip is soldered to the bond pad. This is done at or around the connection part of the bond clip, which is arranged to provide the connection to the bond pad of the semiconductor die.

In an example of the disclosure, the bond clip comprises a dimple that extends downward, with the connection part of the bond clip located at a bottom side of the dimple.

The bond clip is designed such that a downward extending dimple is provided for allowing the connection part of the bond clip to connect with the bond pad of the semiconductor die.

In an example of the disclosure, the buffer layer partially covers the connection part thereby allowing a remaining part of the connection part to be soldered to the bond pad.

The connection part may comprise a slope. The buffer layer may be present at the slope of the connection part. The buffer layer may also be provided at a bottom side of the dimple. It is the bottom part that may be connected to the bond pad of the semiconductor die.

Parts of the connection part may not be covered such that soldering is still possible - in order to keep a solderability of the bond pad with the bond clip. It may be more difficult to use the buffer material for soldering purposes as it may be dissolved or it may react with the solder.

In an example of the disclosure, the buffer layer fully covers the connection part - or at least the bottom side of the connection part -, wherein a thickness of the buffer layer is reduced at an end side of the buffer layer thereby allowing the connection part to be soldered to the bond pad through the buffer layer at the end side having the reduced thickness.

Similar to the previous example and following the downsides, the material of the buffer layer may be dissolved in or may react with the solder. This may be used at the slope part of the connection part, where, in this example, the buffer layer is present. This part of the buffer layer may be in contact with the solder and may be dissolved. The part of the buffer layer contacting the bond pad may not be or is less dissolved since no or less solder is present in this region.

In an example of the disclosure, at least a part of the buffer layer has a thickness of between 2 - 4 µm.

The inventors have found that this thickness is sufficient for allowing the enhanced reliability without compromising conductivity of the copper bond clip.

In an example of the disclosure, the buffer layer is formed by a plating layer applied to the bond clip.

A plating layer as the buffer layer may be beneficial, as it may be integrally manufactured, without needing an additional step of carefully coating the connection part of the bond clip.

In an example of the disclosure, the bond clip further comprises a solderable plating layer provided against the plating layer.

The additional solderable plating layer may be used to "shield" the buffer layer, which is also plated, from the solder. It allows the bond clip to be easily soldered to the bond pad as is done in the process steps. Further it still allows the softer material of the buffer layer to help in decreasing the strain at the connection zone, this is because the softer buffer layer may still be compressed through pressure applied at the solderable plating layer.

In an example of the disclosure, the solderable plating layer comprises a solderable material being any of copper, Cu, or silver, Ag, or nickel, Ni.

The solderable layer comprising a solderable material preferably comprises copper. Nickel may be alternatively used, which has the same advantages as copper in shielding the buffer layer. Nickel furthermore has a better corrosion and oxidation resistance compared to copper. Nickel on the other hand has worse wettability and adhesion to mould compounds compared to copper. Nickel is chosen for applications needing better corrosion and oxidation resistance, and where mechanical strength and durability are important. It is less suitable for applications requiring high thermal or electrical conductivity, which copper is more suitable for.

In an example of the disclosure, the plating layer:
- is provided at a bottom side of the bond clip, or
- is provided at a bottom side and a top side of the bond clip.

Plating may be performed for the bottom side of the bond clip, which is the side facing the semiconductor die, or also a top side of the bond clip. Providing the plating layer at both the bottom side and the top side may be advantageous as it provides a better distribution of mechanical stress over the bond pad. It may further be useful when manufacturing processes are configured to provide a both-side plated bond clip. For reducing solder creep strain to minimize solder cracking risks, at least the bottom side, and at least the connection part should be covered with the plating.

In an example of the disclosure, the plating layer comprises silver, Ag, and wherein a thickness of the plating layer is, at least at a part of the connection part, at least 10 µm such that the connection part can be soldered to the bond pad through the plating layer.

The plating layer may comprise silver, it may further be provided that both the plating layer and the soldering layer may be silver. This negates the advantage of shielding the buffer layer, but it allows the solderable material to itself have a lower hardness, which may be beneficial for lowering the strain on the bond pad and connection part. It should be noted that silver is used for both the solderable and the buffer layer, the (combined) thickness of the layer(s) may be at least 10 µm. This is due to the fact that some silver may be dissolved into or may react with the solder. This reduces the thickness of the layer(s). Therefore, if a silver layer is to remain, the thickness may be at least 10 µm.

In an example of the disclosure, a material of the buffer layer is any of Silver, Ag, or Aluminium, Al.

Silver or aluminium may be used as a material with a lower hardness than copper, this is advantageous as it may reduce die stress, leading to lower cracking risks and therefore better reliability and performance.

In an example of the disclosure, the dimple comprises a first and a second dimple, wherein a first dimple extends downward and wherein the second dimple extend downward from the first dimple, and wherein the connection part is provided on a bottom side of the second dimple.

A second dimple, which may be thought of as a protrusion, locally reduces the footprint of the connection part. A reduced footprint, which may alternatively be named the dimple size, may increase the robustness of the solder. This is beneficial as the goal is to reduce strain at the connection zone, but also at the solder itself. A larger dimple size could increase the solder creep strain, which a smaller dimple would prevent or reduce. This way it limits the solder thickness area underneath small dimple, preferably being negligible or as low as possible and keeps thicker solder (>35µm) in the rest of the connection part area.

In a second aspect of the disclosure, there is provided a method of manufacturing a clip-bonded semiconductor package in accordance with the disclosure, wherein the method comprises the steps of:
- providing the semiconductor die comprising the bond pad wherein the bond pad is arranged to receive the bond clip;
- providing the buffer layer to the bond clip;
- attaching the bond clip to the bond pad wherein the bond clip is arranged to provide electrical connection to the bond pad.

In an example of the disclosure, the step of providing the buffer layer comprises any of:
- plating the bond clip with a plating layer;
- coating the bond clip at the connection part.

Plating the bond clip may be covering the surface of the bond clip facing the bond pad.

Coating the bond clip at the connection part may be covering at least the surface of the connection part facing the bond pad.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

The above and other aspects of the disclosure will be apparent from and elucidated with reference to the examples described hereinafter.

### Brief description of the figures

Fig. 1 depicts a bond clip attached to a bond pad.
Fig. 2 depicts an example of a bond clip according to the disclosure.
Fig. 3 depicts a further example of a bond clip according to the disclosure.
Fig. 4 depicts another example of a bond clip according to the disclosure.
Fig. 5 depicts yet another example of a bond clip according to the disclosure.

### Detailed description

**It** is noted that in the description of the figures, same reference numerals refer to the same of similar components performing a same of essentially similar function.

A more detailed description is made with reference to particular examples, some of which are illustrated in the appended drawings, such that the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

The ensuing description above provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or" in reference to a list of two or more items, covers all the following interpretations of the word: any of the items in the list, all of the items in the list, and any combination of the items in the list.

These and other changes can be made to the technology considering the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein.

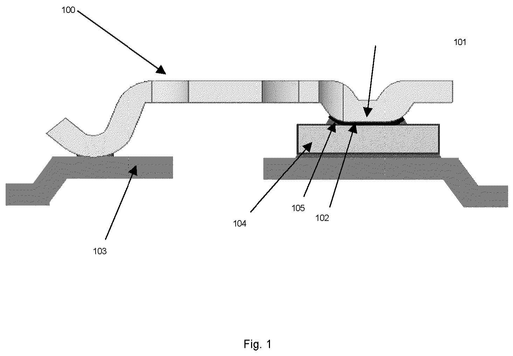

In figure 1, a bond clip 100 in accordance with the disclosure is depicted being attached to a bond pad of a semiconductor die 104. Herein the bond clip 100 can be observed being connected to the bond pad of the semiconductor die 104, wherein a solder 105is used for the connection. Further the semiconductor die 104 is connected with a lead frame 103. The bond clip comprises a connection part 101, which is at least partly provided with a buffer layer 102. This buffer layer is arranged to lower stresses imposed on the semiconductor die 104 during connection of the bond clip 100.

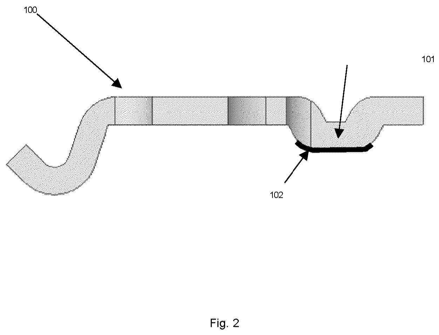

In figure 2, a bond clip 100 in accordance with the disclosure is depicted. Herein, the bond clip 100 is shown separately from other components, such as the semiconductor die. The bond clip comprises a connection part 101, which is at least partly provided with a buffer layer 102. The buffer layer helps to reduce the stress imposed on the die during connection of the bond clip 100. Reducing this stress may reduce the die catering risk during operation. It also allows sufficient thermal mass to limit the temperature increase during forward surge current loads. This results in a robust clip design to enhance package reliability performance, having a reduced die crack and solder crack likelihood, and a better forward surge current performance.

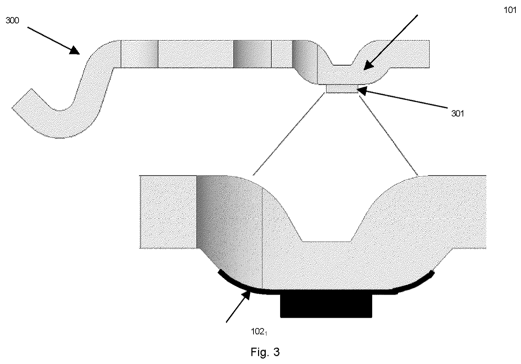

In figure 3, a bond clip 300 in accordance with the disclosure is depicted. Herein the bond clip 300 is shown separately from other components, such as the semiconductor die. The bond clip comprises a connection parts 101, which is at least partly coated with the buffer layer. The connection part further comprises a dimple or protrusion in order to obtain a robust solder reliability performance. However, this dimple alone would decrease the forward surge current, IFSM. Therefore, the buffer layer 102 is applied to mitigate the effects of the smaller connection area of the connection part of the clip with the semiconductor die. The buffer layer will soften the area of connection, allowing it to be elastically deformed, allowing lower stresses between the bond pad and the bond clip. Further, the addition of the dimple allows a thicker solder being applied beneath the clip, next to the dimple to enhance clip solder reliability.

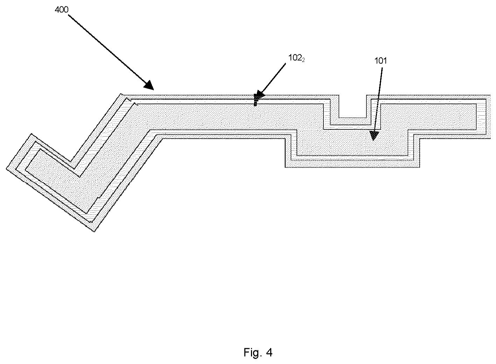

In figure 4, a bond clip 400 in accordance with the disclosure is depicted. Herein the bond clip 400 is, again, shown separately from other components, such as the semiconductor die. The bond clip 400, comprises its connection part 101, wherein in the figure, the bond clip is at least substantially fully plated on all sides with the buffer layer. This plating may be done prior to the formation of the shape of the bond clip or thereafter. In this example, the plating comprises a two-layer plating 102₂, comprising the buffer layer and a solderable plating layer. Herein the advantage is that the buffer layer is able to provide the elastic properties and lower hardness of the bond-clip while the further layer is able to provide the solderability to the semiconductor die, thereby allowing the bond-clip to be connected to the bond pad by soldering.

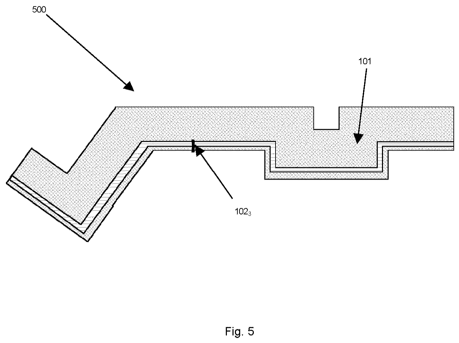

In figure 5, a bond clip 500 in accordance with the disclosure is depicted. Herein the bond clip 500 is, again, shown separately from other components, such as the semiconductor die. The bond clip 500, comprises its connection part 101, wherein in the figure, the bond clip 500 is at least substantially fully plated with the buffer layer on the side in connection to the die. This plating may be done prior to the formation of the shape of the bond clip. In this example, the plating comprises a two-layer plating 102₃, comprising the buffer layer and a solderable plating layer. Herein the advantage is that the buffer layer is able to provide the elastic properties and lower hardness of the bond-clip while the further layer is able to provide the solderability to the semiconductor die, thereby allowing the bond-clip to be connected to the bond pad by soldering.

As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms.

Accordingly, the actual scope of the technology encompasses not only the disclosed examples, but also all equivalent ways of practicing or implementing the technology under the claims.

## Claims

1. A clip-bonded semiconductor package comprising:
- a semiconductor die comprising a bond pad on a top side of the semiconductor die, wherein the bond pad is arranged to receive a bond clip;
- the bond clip arranged to provide electrical connection to the bond pad via a connection part of the bond clip, wherein the bond clip further comprises a buffer layer provided to at least the connection part, wherein a hardness of a material of the buffer layer is lower than a hardness of a material of the bond clip.

2. A clip-bonded semiconductor package in accordance with claim 1, wherein the bond clip is soldered to the bond pad.

3. A clip-bonded semiconductor package in accordance with any of the previous claims, wherein the bond clip comprises a dimple that extends downward, with the connection part of the bond clip located at a bottom side of the dimple.

4. A clip-bonded semiconductor package in accordance with claim 3, wherein the buffer layer partially covers the connection part thereby allowing a remaining part of the connection part to be soldered to the bond pad.

5. A clip-bonded semiconductor package in accordance with claim 3, wherein the buffer layer fully covers the connection part, wherein a thickness of the buffer layer is reduced at an end side of the buffer layer thereby allowing the connection part to be soldered to the bond pad through the buffer layer at the end side having the reduced thickness.

6. A clip-bonded semiconductor package in accordance with any of the previous claims, wherein at least a part of the buffer layer has a thickness of between 2 - 4 µm.

7. A clip-bonded semiconductor package in accordance with any of the claims 1 - 2, wherein the buffer layer is formed by a plating layer applied to the bond clip.

8. A clip-bonded semiconductor package in accordance with claim 7, wherein the bond clip further comprises a solderable plating layer provided against the plating layer.

9. A clip-bonded semiconductor package in accordance with claim 8, wherein the solderable plating layer comprises a solderable material being any of Copper, Cu, or Silver, Ag, or Nickel, Ni.

10. A clip-bonded semiconductor package in accordance with any of the claims 7 - 9, wherein the plating layer:
- is provided at a bottom side of the bond clip, or
- is provided at a bottom side and a top side of the bond clip.

11. A clip-bonded semiconductor package in accordance with claim 7, wherein the plating layer comprises silver, Ag, and wherein a thickness of the plating layer is, at least at a part of the connection part, at least 10 µm such that the connection part can be soldered to the bond pad through the plating layer.

12. A clip-bonded semiconductor package in accordance with any of the previous claims, wherein a material of the buffer layer is any of Silver, Ag, or Aluminium, Al.

13. A clip-bonded semiconductor package in accordance with any of the previous claims and depending on at least claim 3, wherein the dimple comprises a first and a second dimple, wherein the first dimple extends downward and wherein the second dimple extend downward from the first dimple, and wherein the connection part is provided on a bottom side of the second dimple.

14. A method of manufacturing a clip-bonded semiconductor package in accordance with any of the previous claim, wherein the method comprises the steps of:
- providing the semiconductor die comprising the bond pad wherein the bond pad is arranged to receive the bond clip;
- providing the buffer layer to the bond clip;
- attaching the bond clip to the bond pad wherein the bond clip is arranged to provide electrical connection to the bond pad.

15. A method of manufacturing in accordance with claim 14, wherein the step of providing the buffer layer comprises any of:
- plating the bond clip with a plating layer;
- coating the bond clip at the connection part.
